# EUROPEAN PATENT SPECIFICATION

(11) **EP 2 355 641 B1**
(45) Date of publication and mention of the grant of the patent: **02.10.2013**
(21) Application number: 10290023.0
(22) Date of filing: 18.01.2010
(51) Int. Cl.: H05K 7/20

(54) **Heat management in a minaturized base station**
Wärmeverwaltung in einer miniaturisierten Basisstation
Gestion de la chaleur dans une station de base miniaturisée

(43) Date of publication of application: 10.08.2011
(73) Proprietor: Alcatel Lucent, 75007 Paris (FR)
(72) Inventor: Blume, Oliver, 70499 Stuttgart (DE); Braun, Volker, 70178 Stuttgart (DE)
(74) Representative: Wetzel, Emmanuelle

(56) References cited:
- EP-A1- 1 843 476
- US-A- 5 267 122
- US-A- 5 812 373
- US-A- 6 118 662
- US-A1- 2002 008 962
- US-A1- 2004 022 385
- US-A1- 2009 231 815
- US-B1- 6 507 494
- US-B1- 7 372 705

## Description

### Field of the invention

The invention relates to a miniaturized base station apparatus, more specifically to the heat management in a miniaturized base station apparatus.

### Background and related art

For common base stations in mobile telecommunication networks big housings with heavy cooling elements are used for heat management. This limits the miniaturizing of size and weight of base stations. Alternatively active cooling can be used with fans, chillers or Peltier coolers, which adds moving parts, maintenance, power consumption and cost.

US 2004/022385 A1 discloses a thermal design for passively cooled telecommunication repeater housings for use with wire transmission in the local loop outside plant. US 2009/231815 A1 discloses an enclosure device of a wireless communication apparatus, which has a tubular structure with increased heat dissipation. US 5,267,122 A1 discloses an optical network unit for field installation adjacent to an optical fiber transmission line, for separating multiplexed video and telephony signals for delivery to subscribers residences as electrical signals over metallic drop cables with a hollow housing formed of heat-conductive material. US 7,372,705 B1 discloses a data communications device for use in an outdoor environment. The router includes wireless communications circuit boards mounted within an environmentally sealed housing. The housing protects the circuit boards from exposure to extreme environmental conditions such as relatively high temperatures. US 6,118,662 discloses an enclosure for protecting and dissipating heat from telecommunications repeaters. US 6,507,494 B1 discloses an electronic equipment enclosure for housing electronic equipment, and broadly comprising a pivot bracket, a plurality of sleeves, each being associated with a transmit terminal, and a heat sink. The heat sing is operable to facilitate conductive heat transfer between the sleeves and the lid. US 2002/0008962 A1 discloses a telecommunications equipment enclosure that dissipates into the ambient environment heat internally generated by signal repeater cards and other electronic equipment stored therein. US 5,812,373 discloses an outdoor electronics enclosure which provides both weather protection and heat dissipation.

EP 1 843 476 A1 discloses a base station being attached to a mast, wherein the mast is used for dissipating heat.

### Summary of the invention

A miniaturized base station apparatus is understood herein after as a base station for a mobile telecommunication network with smaller dimensions than common base stations of mobile telecommunications network used today. Preferably, a miniaturized base station according to embodiments of the invention has a volume of up to 50 litres.

The invention provides a miniaturized base station apparatus comprising a plurality of active electronic components, a housing and an attachment means. The housing comprises at least one metal component, to which the plurality of electronic devices is connected by means of at least one thermal conductor. The thermal conductor may for example be a heat conducting paste. It is to be noted that also small air gaps are possible in the connection between the plurality of active electronic components and the metal component. Preferably, air gaps shall be avoided for maximizing the heat flow from the electronic devices to the metal component.

The metal component itself is a good thermal conductor and dissipates heat from the electronic devices. By dissipating heat out of the housing a miniaturization of base stations is possible because big heavy cooling elements are not needed in the base station. The number of cooling elements in the base station can be decreased as the metal component dissipates heat from the electronic devices. The attachment means is adapted for fixing the miniaturized base station apparatus to a mounting structure such that the metal component is connected to the mounting structure. Thus a thermal connection is established between the plurality of active electronic components and the mounting structure via the metal component.

Because the metal component is connected to the mounting structure the heat dissipated by the metal component from the electronic devices further flows to the mounting structure. For example, the mounting structure may be a lamp post. This is advantageous because a lamp post is usually made from metal such that the whole lamp post can act as a cooling element for the electronic devices because it is thermally connected to the electronic devices via at least the metal component. Thus, the heat flows from the electronic components to the metal component and from the metal component to the mounting structure, which is preferably a lamp post.

The use of a lamp post as mounting structure is possible because of the small size and low weight of the miniaturized base station. Fixing the miniaturized base station to a lamp post is advantageous because lamp posts are usually installed everywhere in today's towns and cities. Thus, a good network coverage can be achieved by fixing miniaturized base stations to lamp posts.

According to embodiments of the invention the metal component is connected to the plurality of electronic devices with a heat transmission coefficient in a range of 0.03 to 30 watts per meter Kelvin and wherein the metal component is connected to the mounting structure with a heat transmission coefficient in a range of 3 to 500 watts per meter Kelvin. The connection between the plurality of electronic devices and the metal component depends on the material, which is in between the metal component and the plurality of electronic devices. Additionally the number and the size of air gaps between the electronic devices and the metal component have influence on the transmission coefficient. The more and the bigger air gaps are in between the electronic devices and the metal component the worse the thermal conduction is. Thus, for a good thermal conduction air gaps shall be avoided between the metal component and the electronic devices. The connection between the metal component and the mounting structure also depends on the size and number of air gaps in between the metal component and the mounting structure. Preferably, a soft metal film is located in between the metal component and the mounting structure for minimizing air gaps between the metal component and the mounting structure. The soft metal film may for example be made of aluminium, copper, tin, zinc or brass. According to embodiments of the invention the metal component is connected to the plurality of electronic devices via a heat conducting paste or via solder. The metal component may be connected to the mounting structure via a heat conducting paste or by at least one soft metal film. It is to be noted that also a plurality of metal films or a combination of heat conducting paste and a soft metal film is possible. For the connection between the metal component and the electronic devices also a combination of a heat conducting paste and solder is possible. By adding heat conducting paste to one of the two connections air gaps are avoided and the thermal conduction is optimized. This leads to a better thermal conduction.

According to embodiments of the invention a cooling element is connected to the metal component. This makes the heat dissipation of the metal component even better. In this case the heat is dissipated by the cooling element of the metal component and by the mounting structure. The cooling element of the metal component may also be cooling fins. The cooling element of the metal component is preferably located outside the housing.

According to embodiments of the invention at least one cooling element is connected to the mounting structure. This is advantageous because by cooling the mounting structure the metal component and the electronic devices are also indirectly cooled. Thus, the heat management is optimized.

According to embodiments of the invention the cooling element on the mounting structure is a passive cooling element.

According to embodiments of the invention the attachment means for fixing the miniaturized base station apparatus to the mounting structure is a clamp. The clamp is fixed for example with two ends at the metal component and clasps the mounting structure. The fixation of the clamp at the metal component may for example be performed by screws or nails.

According to embodiments of the invention the metal component has an indentation for accommodating a first part of the mounting structure. Preferably, the first part of the mounting structure is in case of a circular mounting structure one half of the cross section of the mounting structure. It is to be noted that other sizes of the first part are possible.

According to embodiments of the invention the attachment means has an indentation for accommodating a second part of the mounting structure. The second part also has preferably the size of half the cross section of the mounting structure in case of a circular mounting structure. The first and the second part are preferably located at the same height of the mounting structure such that when the attachment means are connected to the metal component the mounting structure is completely surrounded by the metal component and the attachment means. Preferably, the attachment means have a large surface connected to the metal component such that also the attachment means function as a heat dissipater. Because the attachment means and the metal component completely clasp the mounting structure the heat flow from the electronic devices via the metal component and the attachment means is optimized because of a large contact surface between the attachment means, the metal component and the mounting structure.

According to embodiments of the invention the attachment means comprises an adaptor for attaching the miniaturized base station apparatus to a structure having a higher curvature than the indentation of the metal component. In case the mounting structure has a higher curvature than the indentation of the metal component the contact surface between the mounting structure and the metal component is not big enough for dissipating enough heat from the electronic devices. By using the adaptor, the contact surface is increased and more heat can be dissipated from the electronic devices.

According to embodiments of the invention the metal component is made from aluminium or copper. These two metals are preferably used for heat management because they are good heat conductors. Aluminium has the advantages of being easily produced, cheap and additionally a good heat conductor. Further, aluminium is a light metal such that the base station apparatus can easily be fixed on a mounting structure.

According to embodiments of the invention the mounting structure may be galvanized or coated. This would lead to a worse heat flow than without the galvanized or coated mounting structure surface. But due to the large surface contact according to the invention still the heat flow is big enough for cooling the electronic devices.

In another aspect the invention relates to a method for heat management in a miniaturized base station apparatus. The miniaturized base station apparatus comprises a plurality of electronic devices, the method comprising the following steps.

A heat flow is established from the electronic devices to a metal component such that the metal component dissipates heat from the electronic devices. Preferably, the heat flow is established via a heat conducting paste or via solder. It is to be noted that also small air gaps may be located in between the electronic devices and the metal component. Such air gaps shall be avoided for maximizing the heat flow from the electronic devices to a metal component.

A heat flow is established from the metal component to a mounting structure. The metal component is attached to the mounting structure with attachment means such that the metal component is connected to the mounting structure. By using the mounting structure as a heat dissipater high amounts of heat may be dissipated. Preferably, the metal component is fixed to the mounting structure with a clamp. A gap due to surface roughness or due to slight deviations from the ideal matching between mounting structure and indentation in the metal component would reduce the heat dissipation. The tightening forces of the clamp are utilised to deform plastically or elastically the metal component or the mounting structure or the heat conducting paste or metal film in the gap, so that the gap is closed or at least reduced.

According to an embodiment of the invention the method comprises further the step of dissipating heat from the mounting structure with at least one cooling element. This helps additionally to dissipate as much heat as possible from the electronic devices.

It is to be noted that the concept of cooling electronic devices according to embodiments of the invention is not limited to the cooling of miniaturized base stations. It is also possible to use the cooling method as it is used in a miniaturized base station according to embodiments of the invention in other electronic apparatuses such as remote radio heads for example.

### Brief description of the drawings

In the following preferred embodiments of the invention will be described, by way of example only, and with reference to the drawings in which:
- Fig. 1: is a schematic view of a miniaturized base station fixed to a mounting structure with a clamp;
- Fig. 2: is a schematic view of a miniaturized base station fixed to a mounting structure with a clamp with an indentation and an adapter;
- Fig. 3: is a schematic view of a miniaturized base station fixed to a mounting structure with a clamp; and an attachment means with two indentations;
- Fig. 4: is a schematic view of a mounting structure with a cooling element; and
- Fig. 5: is a flow diagram of a method for heat management in a miniaturized base station apparatus.

### Detailed description

Like numbered elements in these Figs. are either identical elements or perform the same function. Elements which have been discussed previously will not necessarily be discussed in later Figs. if the function is identical.

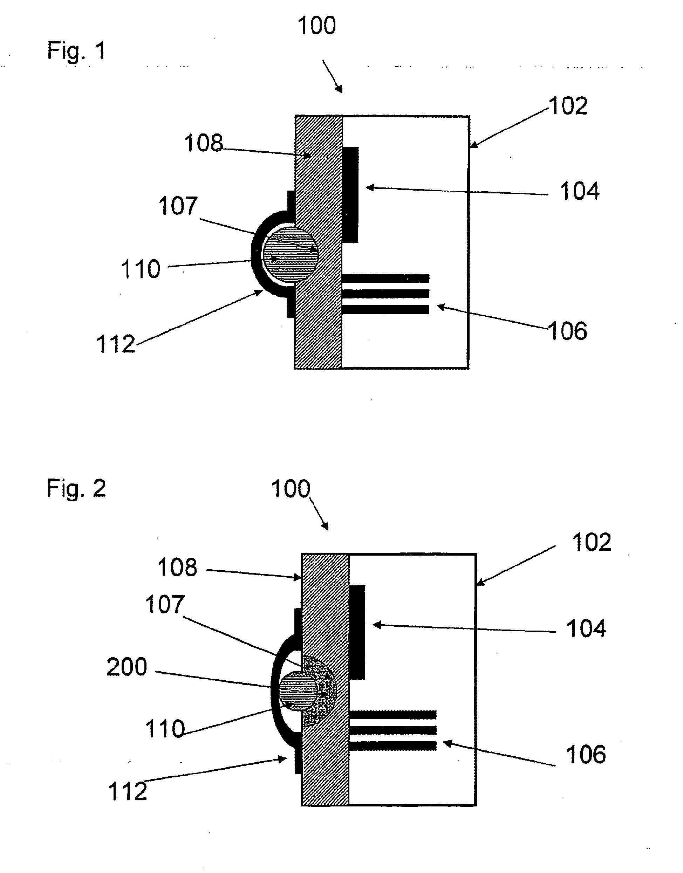

Fig. 1 is a schematic view of a miniaturized base station apparatus 100. The miniaturized base station apparatus 100 comprises a base station housing 102, a power amplifier 104 and a plurality of other electronic devices 106. The base station 100 further comprises a metal component 108, which has an indentation 107. The miniaturized base station apparatus 100 is fixed at the mounting structure 110 with attachment means 112. In Fig. 1 the attachment means 112 is a clamp. Clamp 112 is fixed to the metal component 108 by means of screws or nails. Clamp 112 clasps half the cross section of the mounting structure 110. The other half of the cross section of mounting structure 110 is clasped by indentation 107 of metal component 102.

The electronic devices 106 and the amplifier 104 are connected to metal component 108. The metal component 108 is thermally connected to the amplifier 104 and the electronic devices 106 directly or with a heat conducting paste or via solder. Also air may be in between the metal component and the amplifier 104 and the electronic devices 106 although air decreases the heat flow between the amplifier 104, the electronic devices 106 and the metal component 108. Thus, preferably a heat conducting paste is located between power amplifier 104 and metal component 108 and between electronic devices 106 and metal component 108.

Via the metal component 102 a heat flow is established from the power amplifier 104 and the electronic devices 106 to the mounting structure 110. The contact surface between metal component 108 and mounting structure 110 is increased with the indentation 107. Therefore, the curvature of indentation 107 is equal to the curvature of mounting structure 110. If mounting structure 110 for example is a lamp post, the indentation 107 of the metal component 102 has the curvature of a lamp post. The whole base station apparatus is fixed at the mounting structure with attachment means 112. In this case a clamp is used as attachment means 112. This base station apparatus uses the whole mounting structure 110 as a heat dissipater for electronic devices 106 and power amplifier 104. Thus, less space is needed in the base station for heat management. Metal component 108 also dissipates some heat and mainly transmits the heat flow to the mounting structure 110.

Fig. 2 is a schematic view of a miniaturized base station apparatus 100 with a housing 102, a power amplifier 104, electrical devices 106, a metal component 108 with an indentation 107, attachment means 112 and a mounting structure 110. Here in Fig. 2 the mounting structure 110 has a circular cross section with a curvature that is bigger than the curvature of indentation 107. Thus, an adapter 200 is located between metal component 108 and mounting structure 110. The adapter's curvature is on one side adapted to the curvature of the indentation 107 and on the other side the curvature of the adapter 200 is adapted to clasp the mounting structure 110. Thus, although the curvature of the mounting structure 110 is not identical with the curvature of the indentation 107 of metal component 108 half the cross sectional surface of mounting structure 110 is used for dissipating heat from the metal component 108. Thus, with adapter 200 heat flow is increased.

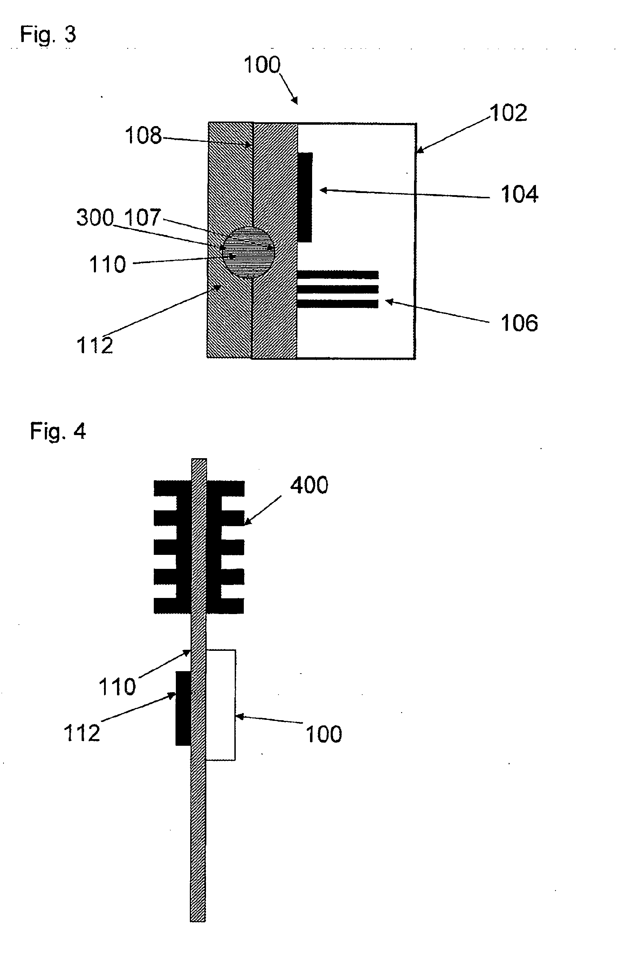

Fig. 3 is a schematic view of a miniaturized base station apparatus 100 and a mounting structure 110. The miniaturized base station apparatus 100 comprises a housing 102, a power amplifier 104, electronic devices 106, a metal component 108 with an indentation 107. The base station apparatus is fixed to the mounting structure 110 with attachment means 112. Attachment means 112 have an indentation 300, which has the same curvature as indentation 107 of the metal component 108. Preferably, this curvature is identical to the curvature of mounting structure 110. Preferably, metal component 108 and attachment means 112 clasp completely a part of mounting structure 110. Therefore, both indentations clasp half the cross section of mounting structure 110.

By fixing base station apparatus 100 in this way to mounting structure 110 the whole surface of a part of mounting structure 110 can be used for heat flow. If for example mounting structure 110 has a circular cross section the whole parameter of this circle is used for dissipating heat from metal component 108 and attachment means 112. By clasping the complete surface of a part of mounting structure 110 heat flow is increased.

Fig. 4 is a schematic view of a mounting structure 110 with a base station apparatus 100 fixed to the mounting structure with attachment means 112. Additionally the mounting structure 110 has a cooling element 400. This is advantageous because the mounting structure 110 is cooled by cooling element 400 and thus the heat flow from the electronic devices (not depicted) in the base station apparatus 100 to the mounting structure 110 is increased. Thus, cooling of electronic devices is improved and less cooling elements are needed in the miniaturized base station apparatus 100. This leads to smaller base station apparatuses 100.

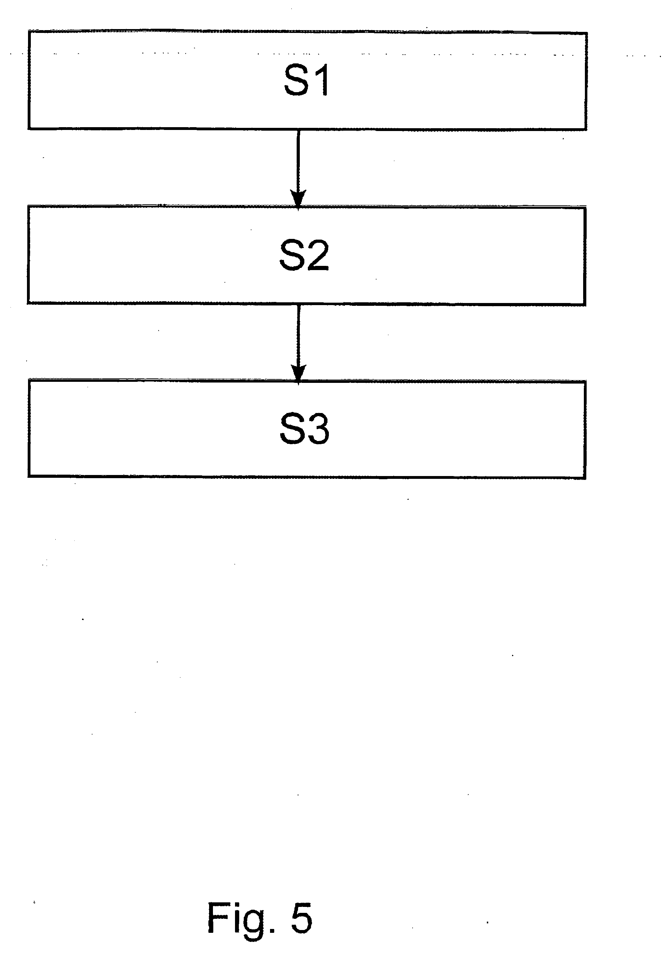

Fig. 5 is a flow diagram of a heat management method in a miniaturized base station. In the first step S1 a heat flow from the electronic devices to a metal component is established such that the metal component dissipates heat from the electronic devices. In step S2 a heat flow from the metal component to a mounting structure is established. Thus, the heat produced by electric devices in a miniaturized base station is dissipated by the metal component and the mounting structure. Preferably, the mounting structure has a large surface compared to the miniaturized base station. Thus, the mounting structure is cooled by its environment in step S3. The cooling of the mounting structure is performed by air, air convection and/or an air flow, for example wind.

Dissipating heat with the mounting structure can even be enhanced by adding a cooling element to the mounting structure. A cooling element - e.g. cooling fins - may also be added to the metal component for cooling the metal component. This - leads to an indirect cooling of the electronic devices.

**List of reference numerals**

| | |
|---|---|
| 100 | Miniaturized base station apparatus |
| 102 | Housing |
| 104 | Power amplifier |
| 106 | Electronic devices |
| 107 | Indentation |
| 108 | Metal component |
| 110 | Mounting structure |
| 112 | Attachment means |
| 200 | Adapter |
| 300 | Indentation |
| 400 | Cooling element |

## Claims

1. A miniaturized base station apparatus (100) comprising a plurality of active electronic components (104; 106), a housing (102) and an attachment means (112), wherein the housing comprises at least one metal component (108), wherein the metal component has an indentation (107) for accommodating a
first part of the mounting structure, wherein the plurality of electronic components is connected to the metal component by means of at least one thermal conductor, wherein the attachment means is adapted for fixing the
miniaturized base station apparatus to a mounting structure (110) to be used as a heat dissipater such that the metal component is in contact with the
mounting structure and that a thermal connection is established between the plurality of active electronic components and the mounting structure.

2. Miniaturized base station apparatus according to claim 1, wherein the metal
component is connected to the plurality of electronic components with a heat transmission coefficient in a range of 0.03-30Wm⁻¹K⁻¹ and wherein the metal component is connected to the mounting structure with a heat transmission coefficient in a range of 3-500Wm⁻¹K⁻¹.

3. Miniaturized base station apparatus according to any one of the preceding
claims, wherein the metal component is connected to the plurality of electronic components via a heat conducting paste or via solder, and wherein the metal
component is connected to the mounting structure via a heat conducting paste or via at least one soft metal film such as an aluminium, copper, tin, zinc or
brass film.

4. Miniaturized base station apparatus according to any one of the preceding claims, wherein a cooling element is connected to the metal component,
wherein the cooling element is located outside the housing.

5. Miniaturized base station apparatus according to any one of the preceding claims, wherein at least one cooling element (400) is connected to the mounting structure.

6. Miniaturized base station apparatus according to claim 5, wherein the cooling element is a passive cooling element.

7. Miniaturized base station apparatus according to any one of the preceding clalms, wherein the attachment means is a clamp.

8. Miniaturized base station apparatus according to any one of the preceding claims, wherein the attachment means has an indentation (300) for accommodating a second part of the mounting structure, wherein the first and the second part are located at the same height of the mounting structure, and wherein the attachment means are connected to the metal component.

9. Miniaturized base station according to any one of the preceding claims,
wherein the attachment means comprises an adapter (200) for attaching the miniaturized base station apparatus to a mounting structure having a higher curvature than the indentation of the metal component.

10. Miniaturized base station apparatus according to any one of the preceding claims, wherein the metal component is made from aluminium or copper.

11. A method for heat management in a miniaturized base station apparatus (100), wherein the miniaturized base station apparatus comprises a plurality of electronic components (104; 106), a housing (102) and an attachment means (112), wherein the housing comprises at least one metal component (108), wherein the metal component has an indentation (107) for accommodating a first part of the mounting structure, wherein the attachment means is adapted for fixing the miniaturized base station apparatus to a mounting structure (110), the method comprising the following steps:
• establishing (S1) a heat flow from the electronic components to the at least one metal component (108) such that the metal component dissipates heat from the electronic components,
• establishing (S2) a heat flow from the metal component to the mounting structure (110), and
• cooling (S3) the mounting structure with air, air convection and/or an air flow.

12. Method according to claim 11, wherein the method comprises further a step of dissipating heat from the mounting structure with at least one cooling element (400).

## Patentansprüche

1. Miniaturisierte Basisstationsvorrichtung (100) mit einer Vielzahl von aktiven elektronischen Komponenten (104; 106), einem Gehäuse (102) und einem Befestigungsmittel (112), wobei das Gehäuse mindestens eine Metallkomponente (108) umfasst, wobei die Metallkomponente eine Einkerbung (107) für die Aufnahme eines ersten Teils der Montagestruktur aufweist, wobei die Vielzahl von elektronischen Komponenten anhand mindestens eines Wärmeleiters an die Metallkomponente angeschlossen sind, wobei das Befestigungsmittel für die Befestigung der miniaturisierten Basisstationsvorrichtung an einer Montagestruktur (110) zur Verwendung als ein Wärmeableiter ausgelegt ist, so dass die Metallkomponente mit der Montagestruktur in Kontakt steht und zwischen der Vielzahl von aktiven elektronischen Komponenten und der Montagestruktur eine thermische Verbindung hergestellt wird.

2. Miniaturisierte Basisstationsvorrichtung nach Anspruch 1, wobei die Metallkomponente mit einer Wärmeübergangszahl in einem Bereich von 0,03-30 Wm' ¹K⁻¹ mit der Vielzahl von elektronischen Komponenten verbunden Ist, und wobei die Metallkomponente mit einer Wärmeübergangszahl In einem Bereich von 3-500 Wm' ¹K⁻¹ mit der Montagestruktur verbunden Ist.

3. Miniaturisierte Basisstationsvorrichtung nach einem beliebigen der vorstehenden Ansprüche, wobei die Metallkomponente über eine Wärmeleitpaste oder durch Löten mit der Vielzahl von elektronischen Komponenten verbunden ist, und wobei die Metallkomponente über eine Wärmeleiltpaste oder über mindestens eine Welchmetallfolie wie beispielsweise eine Aluminium-, Kupfer-, Zinn-, Zink- oder Messingfolle mit der Montagestruktur verbunden ist.

4. Miniaturisierte Basisstationsvorrichtung nach einem beliebigen der vorstehenden Ansprüche, wobei ein Kühlelement mit der Metallkomponente verbunden ist, wobei das Kühlelement außerhalb des Gehäuses angeordnet ist.

5. Miniaturisierte Basisstationsvorrichtung nach einem beliebigen der vorstehenden Ansprüche, wobei mindestens ein Kühlelement (400) mit der Montagestruktur verbunden ist.

6. Miniaturisierte Basisstationsvorrichtung nach Anspruch 5, wobei das Kühlelement ein passives Kühlelement ist.

7. Miniaturisierte Basisstationsvorrichtung nach einem beliebigen der vorstehenden Ansprüche, wobei das Befestigungsmittel eine Befestigungsklammer ist.

8. Miniaturisierte Basisstationsvorrichtung nach einem beliebigen der vorstehenden Ansprüche, wobei das Befestigungsmittel eine Einkerbung (300) für die Aufnahme eines zweiten Teils der Montagestruktur aufweist, wobei der erste und der zweite Teil In derselben Höhe der Montagestruktur angeordnet sind, und wobei die Befestigungsmittel mit der Metallkomponente verbunden sind.

9. Miniaturisierte Basisstationsvorrichtung nach einem beliebigen der vorstehenden Ansprüche, wobei das Befestigungsmittel einen Adapter (200) zum Befestigen der miniaturisierten Basisstationsvorrichtung an einer Montagestruktur, deren Krümmung größer ist als die Einkerbung der Metallkomponente, umfasst.

10. Miniaturisierte Basisstationsvorrichtung nach einem beliebigen der vorstehenden Ansprüche, wobei die Metallkomponente aus Aluminium oder Kupfer gefertigt ist.

11. Verfahren zur Wärmeverwaltung In einer miniaturisierten Basisstationsvorrichtung (100), wobei die miniaturisierte Basisstationsvorrichtung eine Vielzahl von elektronischen Komponenten (104; 106), ein Gehäuse (102) und ein Befestigungsmittel (112) umfasst, wobei das Gehäuse mindestens eine Metallkomponente (108) umfasst, wobei die Metallkomponente eine Einkerbung (107) für die Aufnahme eines ersten Teils der Montagestruktur aufweist, wobei das Befestigungsmittel für die Befestigung der miniaturisierten Basisstationsvorrichtung an einer Montagestruktur (110) ausgelegt Ist, wobei das Verfahren die folgenden Schritte umfasst:
• Herstellen (S1) eines Wärmestroms von der elektronischen Komponente zu der mindestens einen Metallkomponente (108), so dass die Metallkomponente die von der elektronischen Komponente abgegebene Wärme ableitet,
• Herstellen (S2) eines Wärmestroms von der Metallkomponente zu der Montagestruktur (110), und
• Kühlen (S3) der Montagestruktur mit Luft, Luftkonvektion und/oder einem Luftstrom.

12. Verfahren nach Anspruch 11, wobei das Verfahren weiterhin einen Schritt des Ableitens der von der Montagestruktur abgegebenen Wärme mit mindestens einem Kühlelement (400) umfasst.

## Revendications

1. Appareil de station de base miniaturisée (100) comprenant une pluralité de composants électroniques actifs (104 ; 106), un logement (102) et un moyen de fixation (112), le logement comprenant au moins un composant métallique (108), le composant métallique présentant un renfoncement (107) pour recevoir une première partie de la structure de montage, la pluralité de composants électroniques étant reliée au composant métallique au moyen d'au moins un conducteur thermique, le moyen de fixation étant adapté pour fixer l'appareil de station de base miniaturisée à une structure de montage (110) à utiliser comme dissipateur de chaleur de sorte que le composant métallique soit en contact avec la structure de montage et qu'une connexion thermique soit établie entre la pluralité de composants électroniques actifs et la structure de montage.

2. Appareil de station de base miniaturisée selon la revendication 1, dans lequel le composant métallique est relié à la pluralité de composants électroniques avec un coefficient de transmission thermique dans une plage comprise entre 0,03 et 30 Wm⁻¹K⁻¹ et dans lequel le composant métallique est relié à la structure de montage avec un coefficient de transmission thermique dans une plage comprise entre 3 et 500 Wm⁻¹K⁻¹.

3. Appareil de station de base miniaturisée selon l'une quelconque des revendications précédentes, dans lequel le composant métallique est relié à la pluralité de composants électroniques par l'Intermédiaire d'une pâte conductrice de chaleur ou par l'intermédiaire d'une brasure, et dans lequel le composant métallique est relié à la structure de montage par l'intermédiaire d'une pâte conductrice de chaleur ou par l'intermédiaire d'au moins un film métallique souple comme un film d'aluminium, de cuivre, d'étain, de zinc ou de laiton.

4. Appareil de station de base miniaturisée selon l'une quelconque des revendications précédentes, dans lequel un élément de refroidissement est relié au composant métallique, dans lequel l'élément de refroidissement est situé à l'extérieur du logement.

5. Appareil de station de base miniaturisée selon l'une quelconque des revendications précédentes, dans lequel au moins un élément de refroidissement (400) est relié à la structure de montage.

6. Appareil de station de base miniaturisée selon la revendication 5, dans lequel l'élément de refroidissement est un élément de refroidissement passif.

7. Appareil de station de base miniaturisée selon l'une quelconque des revendications précédentes, dans lequel le moyen de fixation est une pince.

8. Appareil de station de base miniaturisée selon l'une quelconque des revendications précédentes, dans lequel le moyen de fixation présente un renfoncement (300) pour recevoir une deuxième partie de la structure de montage, dans lequel la première et la deuxième parties sont situées à la même hauteur de la structure de montage, et dans lequel les moyens de fixations sont reliés au composant métallique.

9. Station de base miniaturisée selon l'une quelconque des revendications précédentes, dans laquelle le moyen de fixation comprend un adaptateur (200) pour fixer l'appareil de station de base miniaturisée à une structure de montage présentant une courbure plus élevée que celle du renfoncement du composant métallique.

10. Appareil de station de base miniaturisée selon l'une quelconque des revendications précédentes, dans lequel le composant métallique est constitué d'aluminium ou de cuivre.

11. Procédé de gestion de la chaleur dans un appareil de station de base miniaturisée (100), l'appareil de station de base miniaturisée comprenant une pluralité de composants électroniques (104 ; 106), un logement (102) et un moyen de fixation (112), le logement comprenant au moins un composant métallique (108), le composant métallique présentant un renfoncement (107) pour recevoir une première partie de la structure de montage, le moyen de fixation étant adapté pour fixer l'appareil de station de base miniaturisée à une structure de montage (110), le procédé comprenant les étapes suivantes :
• établir (S1) un flux de chaleur entre les composants électroniques et l'au moins un composant métallique (108) de sorte que le composant métallique dissipe la chaleur provenant des composants électroniques,
• établir (S2) un flux de chaleur entre le composant métallique et la structure de montage (110), et
• refroidir (S3) la structure de montage avec de l'air, une convection d'air et/ou un courant d'air.

12. Procédé selon la revendication 11, dans lequel le procédé comprend en outre une étape de dissipation de la chaleur provenant de la structure de montage avec au moins un élément de refroidissement (400).
